(19)

Europäisches
Patentamt

European
Patent Office

Office européen
des brevets

(11) EP 2 662 984 A1

(12) EUROPEAN PATENT APPLICATION

(43) Date of publication:
13.11.2013 Bulletin 2013/46

(51) Int Cl.:
H03M 1/80 (2006.01)

(21) Application number: 12167090.5

(22) Date of filing: 08.05.2012

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR
Designated Extension States:
BA ME

(72) Inventors:
• Gong, Shaofang
603 66 Norrköping (SE)
• Östh, Joakim
603 51 Norrköping (SE)

(74) Representative: Bokinge, Ole
Awapatent AB
Junkersgatan 1
582 35 Linköping (SE)

(71) Applicants:
• Gong, Shaofang
603 66 Norrköping (SE)
• Östh, Joakim
603 51 Norrköping (SE)

(54) **Reflection based modulator and method for reflection based modulation**

(57) The present invention relates to a reflection based modulator (1) for N parallel binary valued data-streams ($D_1$, $D_2$). The reflection based modulator comprises a main multi-port structure (10) comprising O ports ($P_1$-$P_6$), wherein one ($P_2$) of the O ports is used as an input port for a carrier signal ($a_{P2}$), and another ($P_1$) of the O ports is used as an output port for a modulated signal ($b_{P1}$), and wherein the remaining O-2 ports ($P_3$-$P_6$) in the main multi-port structure each is connected to a reflection coefficient generating system (20a-d). Each re-flection coefficient generating system comprises N binary valued impedance loads (Z) each adapted to receive and to be controlled by one of the N parallel binary valued data-streams respectively. Each impedance load is adapted to receive an input signal and return a reflected signal, wherein the reflection coefficient is dependent on the received binary valued datastream, and the N reflected signals generated in the reflection coefficient generating system are adapted to be returned to the main multi-port structure as a combined reflection coefficient signal ($a_{P3}$-$a_{P6}$).

Fig. 2

EP 2 662 984 A1

Printed by Jouve, 75001 PARIS (FR)

**Description**

<u>Technical Field</u>

The present disclosure relates to a modulator, and especially to a transmission modulator based on reflection coefficients from impedance loads. The present invention further relates to a method for reflection based modulation.

<u>Background</u>

In a transmitter chain, Digital-to-Analog Converter (DAC) is used to convert digital input data to an analog signal. The analog signal is used as input to a modulator. The output from the modulator is commonly amplified by a power amplifier before the signal is transferred to an antenna for transmission.

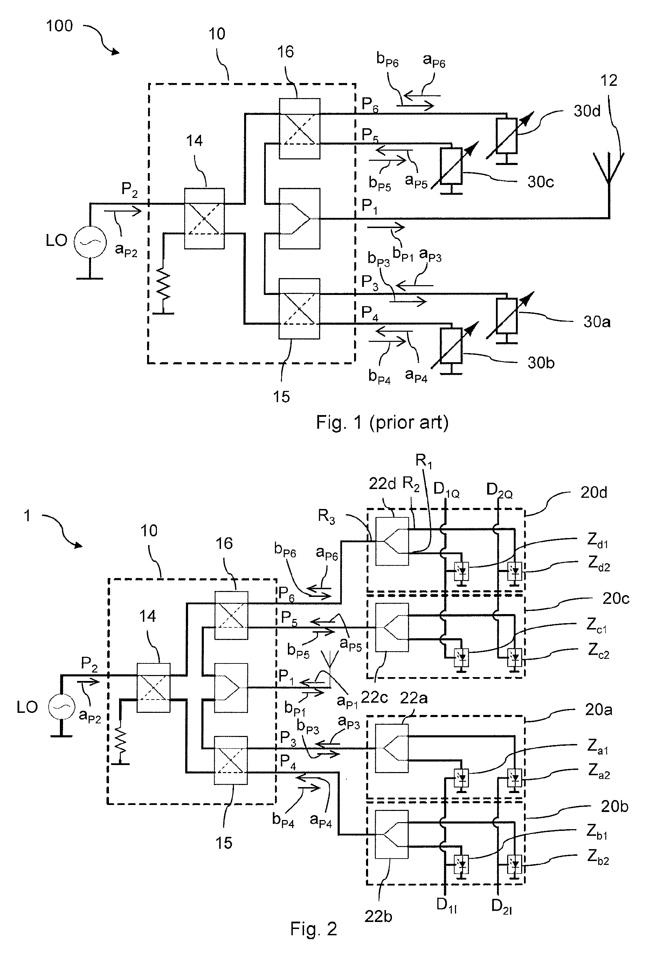

The use of a power amplifier may be avoided by using a reflection based modulator utilizing multi-port technique, such as an exemplary six-port modulator as shown in fig. 1. Such six-port modulator may be used for multi-level M-QAM modulation, such as 16-QAM or 256-QAM. The six-port modulator is capable of supporting high input/output power, providing a high power throughout the modulator, and thereby avoiding the need of a separate power amplifier. The six-port modulator receives a local oscillator input (LO) which is distributed to four of the six ports. From each of these four ports, a modified signal is returned back as a reflection coefficient, wherein the modification depends on a digital signal input to components at each of the four ports.

The different reflection coefficients are generated by changing impedance load, commonly implemented by transistors or diodes. A DAC may be used for controlling the impedance load. However, the non-linear relation between impedance and reflection coefficient in a six-port modulator increases the number of bits required by the DAC. The non-linear relation may also limit the efficiency of the multi-port modulator.

By changing the state of the impedance load, and therefore the corresponding reflection coefficient seen on one or more of the ports of the six-port structure, a modulated Radio Frequency (RF) signal is generated from the input LO signal and the reflection coefficients.

The number of different states each load needs to attain depends on the required modulation order. As the modulation order increases, the number of states of the impedance load and the control signal increases. In a digital radio all information is based on binary valued signals, i.e., only two possible states exist (1 or 0). In a digital radio modulator based on the multi-port structure (e.g., a six-port) with variable impedance loads, the binary valued information must be converted to analog form to generate the control signal, that in turn change the impedance state of the impedance load to generate the required reflection coefficients required for high-order modulation, like M-QAM.

The conversion from the digital domain to the analog domain is usually done by using a DAC. The input to the DAC is a stream of digital data and the output is an analog signal. By using a DAC the required control signal to each impedance load can be generated.

The input signal to an N-bit DAC is N binary valued data-streams $D_1$, $D_2$,..., $D_N$ and $2^N$ different analog levels are possible.

Because the reflection coefficient is a non-linear function of the impedance load and a common DAC implementation uses a fixed step size, the number of bits required in the DAC is higher than the number of bits required to describe all possible states of the reflection coefficient for a given modulation scheme. This makes such modulator comprising a DAC very complex when the number of bits for a modulation scheme increases. A further negative limitation with a DAC is that its speed is limited, and it consumes power. A further drawback of the modulator as in fig. 1 is that the binary baseband data only may generate two impedance states, resulting in the highest order of QPSK (Quadrature Phase Shift Keying) modulation.

An alternative of using a DAC to control an impedance load based on digital control signals to generate different reflection coefficients may be to, at each of the four ports in the six-port modulator, provide a switch matrix controlled by a digital control signal. The switch matrix directs the input signal to different impedance loads based on the digital control signal. For instance, a digital zero in the control signal makes the switch matrix to direct the input signal to a first impedance load which generates a first reflection coefficient, and correspondingly, a digital one makes the switch direct the input signal to a second impedance load providing a second reflection coefficient. The use of a DAC may thereby be avoided. However, the switches may still have limitations in speed, and when the number of bits in the modulation scheme increase, the number of needed impedance loads may increase rapidly. For instance, for a 64-QAM modulation, $\sqrt{M} = \sqrt{64} = 8$ impedance loads are needed for 3 incoming digital control signals. The eight impedance loads each have different impedance values corresponding to different digital inputs from the control signals.

Consequently, there is a need for a simplified solution for a reflection based modulator which at least alleviates the mentioned problems with present devices.

Summary

It is an object of the present invention to provide an improved solution that alleviates the mentioned drawbacks with present devices.

According to an aspect of the invention, a reflection based modulator for N parallel binary valued data-streams is provided. The reflection based modulator comprises a main multi-port structure comprising O ports, wherein one of the O ports is used as an input port for a carrier signal, and another of the O ports is used as an output port for a modulated signal, and wherein the remaining O-2 ports in the main multi-port structure each is connected to a reflection coefficient generating system. Each reflection coefficient generating system comprises N binary valued impedance loads each adapted to receive and to be controlled by one of the N parallel binary valued data-streams respectively. Each impedance load is adapted to receive an input signal and return a reflection coefficient dependent on the received binary valued data-stream, and the N reflection coefficients generated in the reflection coefficient generating system are adapted to be returned to the main multi-port structure as a combined reflection coefficient signal.

By using such modulator, N binary valued impedance loads may be used in each reflection coefficient generating system instead of changing the control signal to each impedance load in $2^N$ different steps as in a solution comprising a DAC. Only two states may then be needed for each impedance load. The actual state of the n:th impedance load may be decided by the binary valued data-stream $D_n$. This provides further that the modulator according to the present invention may be implemented with optical control signals, i.e. optical binary valued data-streams D, which may control an optical impedance load, such as a photo diode or a photo transistor. Further, by using the reflection coefficient generating system, no extra bits may be required to account for non-linear behavior in the reflection coefficient. Only binary valued impedance loads may be used in the reflection coefficient generating system and the efficiency may be increased and the power consumption may be reduced. The speed limitations in using a DAC may be avoided with the present solution. The modulator according to the present invention may further avoid problems with linearity present in known devices, providing better modulation performance. The number of impedance loads at each of the O-2 ports in the main multi-port structure may in the modulator according to the present invention be kept low, i.e. equal to the number of incoming binary valued data-streams. The modulator according to the present invention may further provide that the baseband data, either electrical or optical, may generate modulation in higher order than QPSK, such as 64-QAM or 256-QAM, without the use of a DAC.

In one embodiment, each impedance load $Z_n$ may be adapted to attain one of two possible states, generating two different reflection coefficients, depending on the binary value on the respective data-stream $D_n$.

The actual value of the reflection coefficients is a function of the actual impedance states of each of the N impedance loads and the phase and amplitude characteristics in the reflection coefficient generating system. By properly selecting the amplitude and phase characteristics of the reflection coefficient generating system, the equivalent reflection coefficient may be the same as if a DAC was used to control the impedance load.

In another embodiment, the reflection coefficient generating system may comprise a second multi-port structure, wherein the second multi-port structure may comprise N+1 ports, wherein a first port of the second multi-port structure is connected to one of the O-2 ports in the main multi-port structure, and wherein the additional N ports in the second multi-port structure each may be connected to one of the impedance loads.

The second multi-port structure may be used for combining the signals from the N impedance loads in the reflection coefficient generating system. The amplitude and phase characteristics of the second multi-port structure may be selected to achieve the desired reflection coefficients from the connected impedance loads.

In a further embodiment, the first port in the second multi-port structure may be an input/output port adapted to receive an input signal, divide and distribute the input signal to each of the N impedance loads, and to return a combined reflection coefficient to the main multi-port structure.

The combined reflection coefficient may be a combination of reflection coefficients from all impedance loads in the reflection coefficient generating system. The main multi-port structure may further combine a plurality of such combined reflection coefficients from a plurality of reflection coefficient generating systems. The second multi-port structure may be adapted to receive a carrier signal as input signal, which carrier signal may be adapted to be returned to the main multi-port structure in a modulated form with the combined reflection coefficient. The distribution of the input signal and the combination of reflection coefficients in the second multi-port structure may be made to enable M-QAM modulation. This may provide a combination method with a power ratio scaling between the reflection coefficients at different ports. For instance a ratio of ½ between two adjacent ports in relation to the input signal may be used.

In one embodiment, the impedance loads may be diodes, transistors, switches, photo diodes or photo transistors.

The modulator and reflection coefficient generating system according to the present invention may not be dependent on the control signal being electrical or optical. The type of impedance load may be selected based on the type of control signal providing the binary valued data-streams. Besides the impedance load, the reflection coefficient generating system may be similar independent of the type of control signal.

In another embodiment, the reflection coefficient generating systems connected to the O-2 ports of the main multi-port structure may be divided into an In-phase channel group and a Quadrature-phase channel group, adapted to provide In-phase (I-phase) channel and Quadrature-phase (Q-phase) channel components in a multilevel modulation.

The modulator may comprise a plurality of reflection coefficient generating systems. The reflection coefficient generating systems may be divided into two groups for providing a multilevel M-QAM modulation scheme. One of the groups may be adapted to provide an I-phase channel component, and the other group may provide a Q-phase channel component. Modulated signals for an M-QAM modulation may thereby be provided for a modulated RF output signal from the modulator.

According to a second aspect of the invention, a method of modulating an analog signal based on N parallel binary valued data-streams is provided. The method comprises the steps of providing a carrier signal to an input port of a main multi-port structure comprising O ports, distributing the carrier signal to reflection coefficient generating systems provided at the O-2 ports of the main multi-port structure, distributing, in each reflection coefficient generating system, the carrier signal as an input signal to N binary valued impedance loads, wherein each impedance load is adapted to return a reflection coefficient as a response to the input signal and adapted to receive and be controlled by one of the binary valued data-streams, and returning a combined reflection coefficient based on the N reflection coefficients from the impedance loads to the main multi-port structure.

By providing the carrier signal to N impedance loads, equal to N binary valued data-streams, an effective modulation may be performed with binary valued impedance loads without the speed limitations of a DAC in a traditional modulator. The impedance loads may only need two states.

In one embodiment, the method further may comprise a step of combining the reflection coefficients from the reflection coefficient generating systems to a modulated output signal.

The O-2 reflection coefficient generating systems may each provide a reflection coefficient based on its N impedance loads. These reflection coefficients may be used to generate a modulated output signal. The reflection coefficient generating systems may be divided into an I-phase channel group and a Q-phase channel group for multi-level M-QAM modulation.

In another embodiment, the reflection coefficient returned from an impedance load may depend on the binary value of the controlling data-stream.

Each impedance load may only need two different states. The state of the impedance load may be controlled by the incoming binary valued data-stream. The state of the impedance load affects the returned reflection coefficient from that impedance load.

Brief Description of the Drawings

The invention will in the following be described in more detail with reference to the enclosed drawings, wherein:

Fig. 1 is a block scheme of a commonly known reflection based modulator;
Fig. 2 is a block scheme of a reflection based modulator according to an embodiment of the present invention;
Fig. 3 is a block scheme of a reflection coefficient generating system according to an embodiment of the present invention;
Fig. 4 is a block scheme of a reflection based modulator according to an embodiment of the present invention; and
Fig. 5 is a block scheme of a reflection based modulator according to an embodiment of the present invention;

Description of Embodiments

The present invention will be described more fully hereinafter with reference to the accompanying drawings, in which preferred embodiments of the invention are shown. This invention may, however, be embodied in many different forms and should not be construed as limited to the embodiments set forth herein; rather, these embodiments are provided so that this disclosure will be thorough and complete, and will fully convey the scope of the invention to those skilled in the art. In the drawings, like numbers refer to like elements.

Fig. 1 illustrates a prior art reflection based modulator 100 comprising a main multi-port structure 10. The main multi-port structure 10 comprises O number of ports $P_1, P_2,... P_O$ here illustrated as a main six-port structure 10 with six ports (O=6). An input port $P_2$ in the six-port structure 10 is adapted to receive an input carrier signal $a_{P2}$ from a Local Oscillator (LO). An output port $P_1$ in the six-port structure 10 is adapted to provide a modulated RF signal $b_{P1}$ for transmission to an antenna 12. At each of the remaining four (O-2) ports $P_3$-$P_6$, a variable impedance load 30a-30d is arranged, which each is controlled by a DAC (not shown). The carrier signal $a_{P2}$ is distributed within the six-port to the O-2 ports $P_3$-$P_6$ with different phases. The different phases are multiples of 90°. The amplitude of the carrier signal $a_{P2}$ is the same. The six-port structure 10 comprises three phase modulators 14, 15, 16. The phase modulators 14, 15, 16 provide that the signal supplied to port $P_3$ is phase shifted -360°, the signal to port $P_4$ is phase shifted -270°, the signal to port $P_5$ is phase shifted -270° and the signal to port $P_6$ is phase shifted -180°, all in relation to the carrier signal $a_{P2}$

at port $P_2$. At each O-2 port $P_3$-$P_6$, a distributed carrier signal is sent as an outgoing signal $b_{P3}$-$b_{P6}$ to the DAC controlled impedance load 30a-30d.

Fig. 2 illustrates a reflection based modulator 1 according to the present invention. The main six-port structure 10 is similar to the one illustrated in fig. 1. To each of the four (O-2) ports $P_3$-$P_6$ of the main six-port 10, a reflection coefficient generating system 20a-20d is arranged. To each reflection coefficient generating system 20a-20d, a distributed carrier signal is sent as outgoing signal $b_{P3}$-$b_{P6}$ respectively.

The six-port structure 10 enables the presence of In-phase (I) and Quadrature-phase (Q) data in the modulated RF signal $b_{P1}$. The outgoing signals $b_{P3}$-$b_{P6}$ provided at each of the O-2 ports $P_3$-$P_6$ are returned as incoming signals $a_{P3}$-$a_{P6}$ which are based on reflection coefficients $\Gamma_{P3}$-$\Gamma_{P6}$ for each reflection coefficient generating system 20a-20d. The reflection coefficients $\Gamma_{P3}$, $\Gamma_{P4}$ returned at ports $P_3$ and $P_4$ are combined in a common phase by phase shifting the reflection coefficient $\Gamma_{P3}$ from port $P_3$ in phase modulator 15. The reflection coefficients $\Gamma_{P5}$, $\Gamma_{P6}$ returned at ports $P_5$ and $P_6$ are combined in a common phase by phase shifting the reflection coefficient $\Gamma_{P6}$ from port $P_6$ in phase modulator 16. The reflection coefficients $\Gamma_{P3}$, $\Gamma_{P4}$ at ports $P_3$ and $P_4$ thereby form an I-phase component, and the reflection coefficients $\Gamma_{P5}$, $\Gamma_{P6}$ at ports $P_5$ and $P_6$ form a Q-phase component to the modulated RF signal.

In the six-port structure 10, the modulated RF signal at port $P_1$ is an output wave $b_{P1}$ generated based on the LO input wave $a_{P2}$ at port $P_2$ and the reflection coefficients $\Gamma_{P3}$-$\Gamma_{P6}$ such that

$$b_1 = -\frac{a_2}{4}\left[(\Gamma_3+\Gamma_4)+j(\Gamma_5+\Gamma_6)\right].$$

This may further be expressed as

$$b_1 = -\frac{a_2}{2}\left[\Gamma_I + j\Gamma_Q\right],$$

wherein $\Gamma_3+\Gamma_4=\Gamma_I$ and $\Gamma_5+\Gamma_6=\Gamma_Q$.

The six-port structure 10 may be implemented using different techniques, such as distributed transmission lines, coupled lines, lumped components (discrete capacitors, inductors, transformers, resistors), waveguides or any combination thereof. The above description of a main multi-port structure with O=6 ports may be applied on a main multi-port structure with a variety of number of ports $P_1$, $P_2$,..., $P_O$.

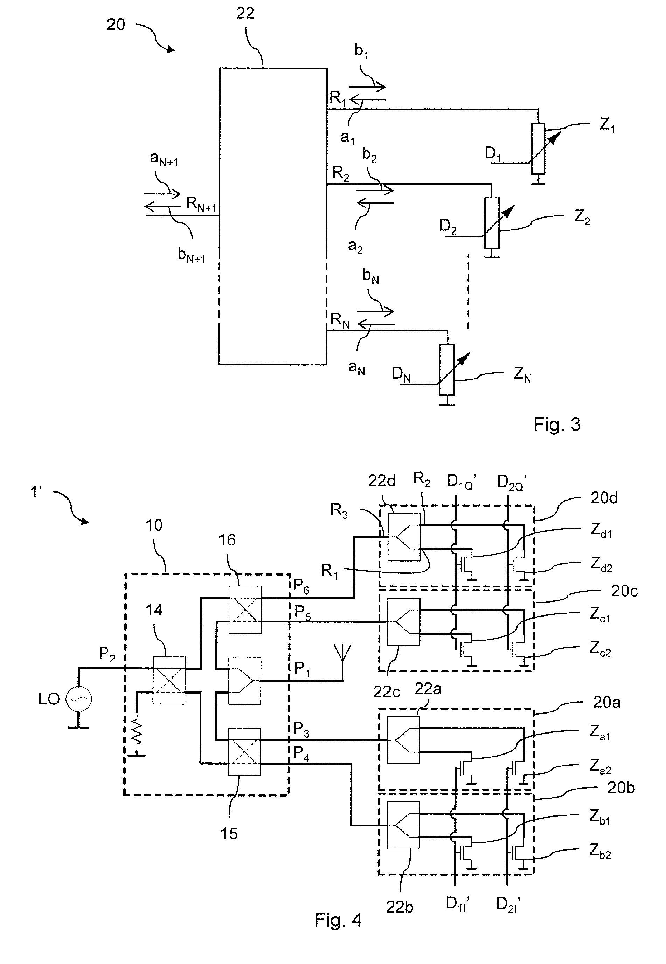

Fig. 3 illustrates a reflection coefficient generating system 20 comprising a plurality of impedance loads $Z_1$, $Z_2$,..., $Z_N$.

The input signal to the reflection coefficient generating system 20 to generate a reflection coefficient $\Gamma$ is N parallel binary valued data-streams $D_1$, $D_2$,..., $D_N$. The value on any data-stream $D_n$ needs only two states (binary valued). The two states are denoted by $V_H$ and $V_L$, where $V_H$ corresponds to a logical one (1) and $V_L$ to a logical zero (0).

Each data-stream $D_n$ has a corresponding impedance load $Z_n$. The actual state of the impedance load $Z_n$ is controlled by the actual value on the binary valued data-stream $D_n$. The two possible states for each load $Z_n$ is denoted by $Z_H$ and $Z_L$.

To each impedance load $Z_n$, there is a corresponding reflection coefficient $\Gamma_n$ from the impedance load $Z_n$. The two possible states, $Z_H$ and $Z_L$ for the impedance load $Z_n$ give two possible states for the corresponding reflection coefficient $\Gamma_n$. The two possible states for $\Gamma_n$ are denoted by $\Gamma_H$ and $\Gamma_L$.

The reflection coefficient generating system 20 comprises a second multi-port structure 22 which is a multi-port structure with N+1 ports. N is the number of binary valued impedance loads and correspondingly the number of parallel binary valued data-streams $D_1$, $D_2$,..., $D_N$. The second multi-port structure 22 is adapted to generate a reflection coefficient $\Gamma_{N+1}$ on its input/output port $R_{N+1}$ as a function of the binary states of the reflection coefficients $\Gamma_1$, $\Gamma_2$,..., $\Gamma_N$ present at each of the N ports $R_1$,..., $R_N$. Each of the N ports is connected to an impedance load $Z_1$, $Z_2$,..., $Z_N$.

The function of the second multi-port structure 22 may be described using definitions and principles from basic RF (Radio Frequency) and microwave theory. An input wave to the second multi-port structure 22 is denoted an and an output wave from the second multi-port structure 22 is denoted $b_n$. This provides a reflection coefficient as $\Gamma_n = b_n/a_n$. The relation between the incoming $a_n$ and outgoing waves $b_n$ can be described using scattering parameters (S-parameters). S-parameter is for instance explained in D. Pozar; Microwave Engineering; 2011; ISBN 0470631554.

At the input/output port $R_{N+1}$ an incoming wave $a_{N+1}$ is received, which originates from the LO carrier signal provided from port P2 in the main multi-port structure 10. The incoming wave $a_{N+1}$ is divided and transferred to the N remaining ports $R_1$,..., $R_N$ in the second multi-port structure 22. Each of these N ports is connected to an impedance load $Z_1$, $Z_2$,..., $Z_N$. The incoming wave $a_{N+1}$ is thereby divided to N outgoing waves $b_1$,..., $b_N$ from the second multi-port structure 22 to the N impedance loads $Z_1$,..., $Z_N$. The outgoing wave $b_n$ at port $R_n$ of the second multi-port network 22,

where $n \in \{1, 2,...N\}$, is related to the incoming wave $a_{N+1}$ at port $R_{N+1}$ by S-parameters

$$b_n = S_{n,\,(N+1)}\, a_{N+1}.$$

The outgoing wave $b_n$ at port n of the second multi-port structure reaches a corresponding impedance load $Z_n$. When the outgoing wave $b_n$ reaches the impedance load $Z_n$, reflection occurs and results in an input wave $a_n$ at port $R_n$ in the second multi-port structure 22 for $n \in \{1, 2,..., N\}$. The input wave $a_n$ that is generated due to reflection in $Z_n$ is described by

$$a_n = \Gamma_n \cdot b_n.$$

The reflection coefficient $\Gamma_n$ is controlled by the state of the impedance load $Z_n$ connected to port n.
The outgoing wave $b_{N+1}$ at the input/output port $R_{N+1}$ is provided back to the main multi-port structure 10.
The input wave $a_n$ at port $R_n$ of the second multi-port structure 22 is transferred to the input/output port $R_{N+1}$.

The contribution from an impedance load $Z_n$ at port $R_n$ to the output wave $b_{N+1}$ is denoted $b_{N+1}^{(n)}$, wherein

$$b_{N+1}^{(n)} = S_{(N+1),n}\, a_n.$$

Using the above equations, the individual contribution from an impedance load $Z_n$ at port $R_n$ to the output wave $b_{N+1}$ is

$$b_{N+1}^{(n)} = S_{N+1,n} S_{n,N+1} a_{N+1} \Gamma_n.$$

The total output wave $b_{N+1}$ at the input/output port $R_{N+1}$ of the second multi-port structure is the sum of all individual contributions $b_{N+1}^{(n)}$,

$$b_{N+1} = a_{N+1} \sum_{n=1}^{N} S_{N+1,n} S_{n,N+1} \Gamma_n.$$

The reflection coefficient at port $R_{N+1}$ provided to the main multi-port structure is thereby

$$\Gamma_{N+1} = \frac{b_{N+1}}{a_{N+1}} = \sum_{n=1}^{N} S_{N+1,n} S_{n,N+1} \Gamma_n,$$

which depends on the S-parameters $S_{N+1,n}$, $S_{n,N+1}$ and the value of $\Gamma_n \in \{\Gamma_H, \Gamma_L\}$.
For each reflection coefficient generating system 20 in the reflection based modulator 1, the outgoing wave $b_{N+1}$ is returned to the main six-port structure 10 and becomes the incoming wave $a_{P3}$-$a_{P6}$ at the respective port $P_3$-$P_6$.
Referring back to fig. 2 an example of a reflection based modulator 1 wherein O=6 and N=2 is illustrated. The main multi-port structure 10 thereby comprises a six-port structure 10 with four (O-2) ports $P_3$-$P_6$ connected to one reflection coefficient generating system 20a-d each. N=2 provides that there are two parallel binary valued data-streams $D_1$, $D_2$ to each reflection coefficient generating system 20a-d. To reflection coefficient generating systems 20a and 20b, data-streams $D_{1I}$ and $D_{2I}$ are provided for the two reflection coefficient generating systems 20a and 20b to provide the I-phase component to the modulated RF output signal. To reflection coefficient generating systems 20c and 20d, data-streams $D_{1Q}$ and $D_{2Q}$ are provided for the two reflection coefficient generating systems 20c and 20d to provide the Q-phase component to the modulated RF output signal. The illustrated reflection based modulator 1' may thereby be used for 16-QAM modulation $\left(M=16, \ N = \log_2 \sqrt{M} = 2\right)$

Each reflection coefficient generating system 20a-d comprises a second multi-port structure 22a-d. The second multi-port structures 22a-d comprises N+1 ports as described above. Here N+1=3, i.e. the second multi-port structures each have three ports $R_1$, $R_2$, $R_3$. Two of the ports $R_1$, $R_2$ are each connected to an impedance load. The third port $R_3$ is connected to one of the four (O-2) ports in the main six-port structure 10. In fig. 3 the port numbering is only indicated at second multi-port structure 22d, but applies equally to the other second multi-port structures 22a-c.

The type of impedance load may be chosen depending on requirements on data rate, power handling capacity and the type of control signal available in the data-streams. In this modulator 1, the two impedance loads in each reflection coefficient generating system 20a-d are provided as photo diodes $Z_{a1}$, $Z_{a2}$, $Z_{b1}$, $Z_{b2}$, $Z_{c1}$, $Z_{c2}$, $Z_{d1}$, and $Z_{d2}$. The photo diodes are used for optical control signals. The reflection based modulator 1 may thereby be used with an optical data input without the need of any further optical-to-electrical converter. The photo diodes are connected between ground and one of the ports $R_1$, $R_2$ on the second multi-port structure 22. The binary valued control signals $D_1$, $D_2$ are fed to the light sensitive area of the photo diodes to change the impedance between the two states.

Fig. 4 illustrates a similar reflection based modulator 1', wherein the impedance loads $Z_{a1}$, $Z_{a2}$, $Z_{b1}$, $Z_{b2}$, $Z_{c1}$, $Z_{c2}$, $Z_{d1}$, $Z_{d2}$ in the reflection coefficient generating systems 20a-d are transistors controlled by electrical control signals in the binary valued data-streams $D_{1I}'$, $D_{2I}'$, $D_{1Q}'$, $D_{2Q}'$.

The variable impedance loads may be unbiased field-effect transistors (FET), known as cold-FET. The source terminal of the transistor is connected to ground and the drain terminal to one of the ports $R_1$, $R_2$ on the second multi-port structure 22. The binary valued control signal $D_1$, $D_2$ is connected to the gate terminal of the transistor to change the impedance between the two states.

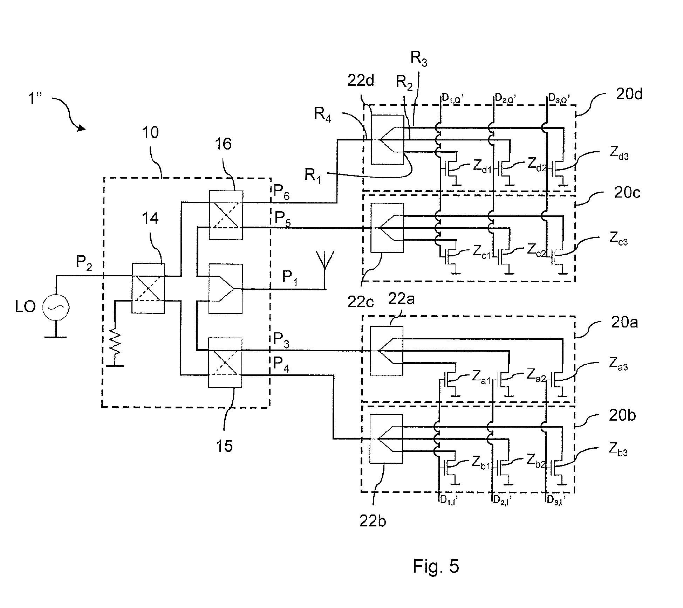

Fig. 5 illustrates a reflection based modulator 1" according to the present invention for 64-QAM modulation. The modulator 1" receives three parallel binary valued data-streams $D_1$, $D_2$, $D_3$, i.e. N=3. The data-streams are provided as electrical control signals $D_{1I}'$, $D_{2I}'$, $D_{3I}'$, $D_{1Q}'$, $D_{2Q}'$, $D_{3Q}'$ to the impedance loads $Z_{a1}$, $Z_{a2}$, $Z_{a3}$, $Z_{b1}$, $Z_{b2}$, $Z_{b3}$, $Z_{c1}$, $Z_{c2}$, $Z_{c3}$, $Z_{d1}$, $Z_{d2}$, $Z_{d3}$, which are provided as FET. Due to N=3, the second multi-port structures 22a-d comprises N+1=4 ports $R_1$, $R_2$, $R_3$, $R_4$.

To design the second multi-port structure, the required S-parameters for the second multi-port structure to support the selected modulation must be found. Symbol points for rectangular M-QAM are distributed in the I and Q phase channels according to

$$-\sqrt{M} + 1 + 2m, \qquad m = 0, 1, ..., \sqrt{M} - 1$$

Therefore, to get a modulated signal according to the equation

$$b_{P1} = -\frac{a_{P2}}{2}\left[\Gamma_I + j\Gamma_Q\right],$$

$\Gamma_{N+1}$ in the equation

$$\Gamma_{N+1} = \frac{b_{N+1}}{a_{N+1}} = \sum_{n=1}^{N} S_{N+1,n} S_{n,N+1} \Gamma_n,$$

must be able to attain all the possible values (i.e., for different m) as shown in

$$\Gamma_{N+1} = k\left(-\sqrt{M} + 1 + 2m\right) + \Gamma_{CM} \quad m = 0, 1, ..., \sqrt{M} - 1,$$

wherein $\Gamma_{N+1}$ correspond to either $\Gamma_3$, $F_4$, $\Gamma_5$ or $\Gamma_6$ in the equation

$$b_{p1} = -\frac{a_{p2}}{4}[(\Gamma_3+\Gamma_4) + j(\Gamma_5+\Gamma_6)].$$

k and $\Gamma_{CM}$ are constants.

By considering all $2^N$ possible combinations (each $\Gamma_n$ can attain two possible states, $\Gamma_H$ or $\Gamma_L$, and in total there are N different reflection coefficients $\Gamma_n$) the required power ratios between the N ports can be found. Assuming the second multi-port structure 22 fulfills $S_{nm} = S_{mn}$, in the case of 16-QAM (M=16), N = 2, there is $2^2 = 4$ possible combinations. The 4 possible combinations are determined to

$$\begin{bmatrix} \Gamma_L\ \Gamma_L \\ \Gamma_L\ \Gamma_H \\ \Gamma_H\ \Gamma_L \\ \Gamma_H\ \Gamma_H \\ D_1 D_2 \end{bmatrix} [S_{13}^2\ S_{23}^2] = k \begin{bmatrix} -3 \\ -1 \\ 1 \\ 3 \end{bmatrix} + \Gamma_{CM} \begin{bmatrix} 1 \\ 1 \\ 1 \\ 1 \end{bmatrix}$$

The two columns (N=2) have been marked with $D_1$ and $D_2$ to emphasis that the actual value on $\Gamma_n \in \{\Gamma_H, \Gamma_L\}$ is controlled by the binary valued data-stream $D_n$. Solving the above equation results in

$$S_{13} = \sqrt{2}S_{23}.$$

Assuming the second multi-port structure 22 divide the input power $W_{in}$ at port $R_{N+1} = R_3$ without any loss to all its output ports $R_1, R_2$:

$$W_3 = W_{in} = W_1 + W_2 = (|S_{13}|^2 + |S_{23}|^2)W_{in} = 3|S_{23}|^2 W_{in},$$

wherein $W_1$ and $W_2$ are the distributed power to ports $R_1$ and $R_2$ respectively.

Hence, $|S_{23}| = \sqrt{1/3}$, $|S_{13}| = \sqrt{2/3}$.

The second multi-port structure 22 can then be designed, in this case for 16-QAM, with an unequal 2-way power divider.

In an ideal case $\Gamma_H = -\Gamma_L = 1$ and the efficiency is maximized. The value on any data-stream $D_n$ may attain only two states (binary valued). The two states are $V_H$ and $V_L$, i.e. $D_n \in \{V_H, V_L\}$. If $V_H = 1$ and $V_L = 0$, then $D_n \in \{1, 0\}$.

$$\Gamma_n = \begin{cases} \Gamma_H = 1 \text{ if } D_n = V_H = 1 \\ \Gamma_L = -1 \text{ if } D_n = V_L = 0 \end{cases}.$$

This may also be expressed as

$$\Gamma_n = -(-1)^{D_n} = \begin{cases} \Gamma_H = 1 \text{ if } D_n = 1 \\ \Gamma_L = -1 \text{ if } D_n = 0 \end{cases}.$$

Using this equation with the derived S-parameters provides that

$$\Gamma_{N+1} = \frac{1}{3}[2\Gamma_1 + \Gamma_2] = -\frac{1}{3}[2(-1)^{D_1} + (-1)^{D_2}].$$

This provides that the relation between the digital control signals $D_n$ and the generated reflection coefficient $\Gamma_{N+1}$ is provided.

To allow for 16-QAM modulation, one data-stream must be used for the I-phase channel and another data-stream for the Q-phase channel. In the illustrated examples in figs. 2, 4, 5, $\Gamma_3 = \Gamma_4 = \Gamma_1$ and $\Gamma_5 = \Gamma_6 = \Gamma_Q$ so that

$$\Gamma_I = -\frac{1}{3}\left[2(-1)^{D_{1,I}} + (-1)^{D_{2,I}}\right],$$

and

$$\Gamma_Q = -\frac{1}{3}\left[2(-1)^{D_{1,Q}} + (-1)^{D_{2,Q}}\right],$$

wherein $D_{n,I}$ is the n:th bit on the I-phase channel and $D_{n,Q}$ is the n:th bit on the Q-phase channel. The total output $b_1$ may thereby be found to be

$$b_{P1} = \frac{a_{P2}}{6}\left[\underbrace{\frac{(2(-1)^{D_{1,I}} + (-1)^{D_{2,I}})}{I - channel}} + j\underbrace{\frac{(2(-1)^{D_{1,Q}} + (-1)^{D_{2,Q}})}{Q - channel}}\right].$$

In the drawings and specification, there have been disclosed preferred embodiments and examples of the invention and, although specific terms are employed, they are used in a generic and descriptive sense only and not for the purpose of limitation, the scope of the invention being set forth in the following claims.

## Claims

1. A reflection based modulator for N parallel binary valued data-streams ($D_1$, $D_2$,..., $D_N$), the reflection based modulator comprising
   a main multi-port structure (10) comprising O ports ($P_1$, $P_2$,..., $P_6$), wherein one ($P_2$) of the O ports is used as an input port for a carrier signal ($a_{P2}$), and another ($P_1$) of the O ports is used as an output port for a modulated signal, wherein the remaining O-2 ports ($P_3$-$P_6$) in the main multi-port structure each is connected to a reflection coefficient generating system (20),
   wherein each reflection coefficient generating system comprises N binary valued impedance loads ($Z_1$, $Z_2$,..., $Z_N$) each adapted to receive and to be controlled by one of the N parallel binary valued data-streams ($D_1$, $D_2$,..., $D_N$) respectively,
   wherein each impedance load is adapted to receive an input signal ($a_{N+1}$) and return a reflection coefficient ($\Gamma_1$, $\Gamma_2$,..., $\Gamma_N$) dependent on the received binary valued data-stream, and
   wherein the N reflection coefficients generated in the reflection coefficient generating system are adapted to be returned to the main multi-port structure as a combined reflection coefficient ($\Gamma_{N+1}$).

2. Reflection based modulator according to claim 1, wherein each impedance load ($Z_n$) is adapted to attain one of two possible states, generating two different reflection coefficients ($\Gamma_H$, $\Gamma_L$), depending on the binary value on the respective data-stream ($D_n$).

3. Reflection based modulator according to claim 1 or 2, wherein the reflection coefficient generating system (20) comprises a second multi-port structure (22), wherein the second multi-port structure comprises N+1 ports, wherein a first port ($R_{N+1}$) of the second multi-port structure is connected to one of the O-2 ports ($P_3$-$P_6$) in the main multi-port structure (10), and wherein the additional N ports ($R_1$, $R_2$,..., $R_N$) in the second multi-port structure each is connected to one of the impedance loads ($Z_1$, $Z_2$,..., $Z_N$).

4. Reflection based modulator according to claim 3, wherein the first port ($R_{N+1}$) in the second multi-port structure (22) is an input/output port adapted to receive an input signal ($a_{N+1}$), divide and distribute the input signal to each of the N impedance loads ($Z_1$, $Z_2$,..., $Z_N$), and to return a combined reflection coefficient ($\Gamma_{N+1}$) to the main multi-port structure (10).

5. Reflection based modulator according to any of the preceding claims, wherein the impedance loads ($Z_1$, $Z_2$,..., $Z_N$) are diodes, transistors, switches, photo diodes or photo transistors.

6. Reflection based modulator according to any of the preceding claims, wherein the reflection coefficient generating systems connected to the O-2 ports of the main multi-port structure (10) are divided into an In-phase channel group and a Quadrature- phase channel group, adapted to provide In-phase channel and Quadrature-phase channel components in a multilevel modulation.

7. Reflection based modulator according to any of the preceding claims, wherein each impedance load ($Z_n$) is adapted to return a signal ($a_n$) generated based on an input signal ($b_n$) to that impedance load and the reflection coefficient ($\Gamma_n$) such that $a_n = \Gamma_n \cdot b_n$.

8. Method of modulating an analog signal based on N parallel binary valued data-streams ($D_1$, $D_2$,..., $D_N$), wherein the method comprises the steps of:

> providing a carrier signal ($a_{P2}$) to an input port ($P_2$) of a main multi-port structure (10) comprising O ports ($P_1$, $P_2$,..., $P_6$),
> distributing the carrier signal to reflection coefficient generating systems (20) provided at the O-2 ports ($P_3$-$P_6$) of the main multi-port structure,
> distributing, in each reflection coefficient generating system, the carrier signal as an input signal to N binary valued impedance loads ($Z_1$, $Z_2$,..., $Z_N$), wherein each impedance load is adapted to return a reflection coefficient ($\Gamma_1$, $\Gamma_2$,..., $\Gamma_N$) as a response to the input signal and adapted to receive and be controlled by one of the binary valued data-streams ($D_1$, $D_2$,..., $D_N$), and
> returning a combined reflection coefficient ($\Gamma_{N+1}$) based on the N reflection coefficients from the impedance loads to the main multi-port structure.

9. Method according to claim 8, further comprising a step of combining the reflection coefficients ($\Gamma_{N+1}$) from the reflection coefficient generating systems to a modulated output signal.

10. Method according to claim 8 or 9, wherein the reflection coefficient ($\Gamma_1$, $\Gamma_2$,..., $\Gamma_N$) returned from an impedance load ($Z_1$, $Z_2$,..., $Z_N$) depends on the binary value of the controlling data-stream ($D_1$, $D_2$,..., $D_N$).

Fig. 1 (prior art)

Fig. 2

Fig. 3

Fig. 4

Fig. 5

**Europäisches Patentamt**
**European Patent Office**
**Office européen des brevets**

# EUROPEAN SEARCH REPORT

Application Number

EP 12 16 7090

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | LUO B ET AL: "Direct 16 QAM six-port modulator", THE INSTITUTION OF ENGINEERING AND TECHNOLOGY. JOURNAL,, vol. 44, no. 15, 17 July 2008 (2008-07-17), pages 910-911, XP006031405, ISSN: 1350-911X, DOI: 10.1049/EL:20080913 | 1-3,6-10 | INV. H03M1/80 |
| Y | * page 910, left-hand column * <br> * page 910, right-hand column * <br> * Equation 1 * <br> * tables 1,2 * <br> * figures 1,2 * <br> ----- | 4,5 | |
| Y | US 2008/106277 A1 (PILLAI EDWARD R [US] ET AL) 8 May 2008 (2008-05-08) <br> * paragraphs [0037] - [0039] * <br> * figures 6,7 * <br> ----- | 4,5 | |
| A | RASHID MIRZAVAND ET AL: "Five-port microwave receiver architectures and applications", IEEE COMMUNICATIONS MAGAZINE, IEEE SERVICE CENTER, PISCATAWAY, US, vol. 48, no. 6, 1 June 2010 (2010-06-01), pages 30-36, XP011310459, ISSN: 0163-6804 <br> * figure 1a * <br> ----- | 1-10 | TECHNICAL FIELDS SEARCHED (IPC) <br><br> H03M |
| A | ADRIANA SERBAN ET AL: "Six-port transceiver for 6-9 GHz ultrawideband systems", MICROWAVE AND OPTICAL TECHNOLOGY LETTERS, vol. 52, no. 3, 1 March 2010 (2010-03-01), pages 740-746, XP55042372, ISSN: 0895-2477, DOI: 10.1002/mop.25021 <br> * Section 2.1, Section 4.3; figure 2; table 1 * <br> ----- | 1-10 | |

-/--

The present search report has been drawn up for all claims

| Place of search | Date of completion of the search | Examiner |
|---|---|---|
| The Hague | 29 October 2012 | Rocha, Daniel |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

Europäisches
Patentamt

European
Patent Office

Office européen
des brevets

# EUROPEAN SEARCH REPORT

Application Number

EP 12 16 7090

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | HAKANSSON P ET AL: "Ultra-wideband six-port transmitter and receiver pair 3.1â 4.8 GHz", MICROWAVE CONFERENCE, 2008. APMC 2008. ASIA-PACIFIC, IEEE, PISCATAWAY, NJ, USA, 16 December 2008 (2008-12-16), pages 1-4, XP031636853, ISBN: 978-1-4244-2641-6 * Section II; figure 1 * | 1-10 | |
| | ----- | | |

TECHNICAL FIELDS
SEARCHED        (IPC)

The present search report has been drawn up for all claims

| Place of search | Date of completion of the search | Examiner |
|---|---|---|
| The Hague | 29 October 2012 | Rocha, Daniel |

CATEGORY OF CITED DOCUMENTS

X : particularly relevant if taken alone
Y : particularly relevant if combined with another
　　document of the same category
A : technological background
O : non-written disclosure
P : intermediate document

T : theory or principle underlying the invention
E : earlier patent document, but published on, or
　　after the filing date
D : document cited in the application
L : document cited for other reasons

& : member of the same patent family, corresponding
　　document

EPO FORM 1503 03.82 (P04C01)

## ANNEX TO THE EUROPEAN SEARCH REPORT
## ON EUROPEAN PATENT APPLICATION NO.

EP 12 16 7090

This annex lists the patent family members relating to the patent documents cited in the above-mentioned European search report.
The members are as contained in the European Patent Office EDP file on
The European Patent Office is in no way liable for these particulars which are merely given for the purpose of information.

29-10-2012

| Patent document cited in search report | | Publication date | Patent family member(s) | | Publication date |
|---|---|---|---|---|---|
| US 2008106277 | A1 | 08-05-2008 | CN | 101173970 A | 07-05-2008 |
| | | | US | 2008106277 A1 | 08-05-2008 |
| | | | US | 2011156730 A1 | 30-06-2011 |

EPO FORM P0459

For more details about this annex : see Official Journal of the European Patent Office, No. 12/82

**EP 2 662 984 A1**

REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **D. POZAR.** *Microwave Engineering,* 2011, ISBN 0470631554